# EUROPEAN PATENT SPECIFICATION

(11) **EP 0 509 844 B1**
(45) Date of publication and mention of the grant of the patent: **09.11.1994**
(21) Application number: 92303500.0
(22) Date of filing: 21.04.1992
(51) Int. Cl.: H05K 7/20

(54) **Apparatus for cooling electronic equipment**
Vorrichtung zum Kühlen einer elektronischen Einrichtung
Appareillage pour le refroidissement d'un dispositif électronique

(30) Priority: 19.04.1991 JP 88820/91
(43) Date of publication of application: 21.10.1992
(73) Proprietor: FUJITSU LIMITED, Kawasaki-shi, Kanagawa 211 (JP)
(72) Inventor: Yamamoto, Haruhiko, c/o Fujitsu Limited, Kawasaki-shi, Kanagawa 211 (JP); Fujisaki, Akihiko, c/o Fujitsu Limited, Kawasaki-shi, Kanagawa 211 (JP)
(74) Representative: Silverman, Warren

(56) References cited:
- EP-A- 0 313 473
- EP-A- 0 421 743
- EP-A- 0 454 123
- EP-A- 0 466 102

## Description

The present invention relates to an electronic equipment cooling apparatus which includes an airtight case accommodating electronic equipment to be cooled and a cooling module: the electronic equipment being cooled by supplying a cooling medium (coolant) to the cooling module.

The current higher processing speeds of supercomputers and the like have resulted in a larger power consumption and higher-density installation. Therefore, to ensure a stable operation, electronic equipment in which semiconductor devices and other electronic components are installed must be cooled to a low temperature, by using a cooling apparatus.

In general, cold water, carbon fluoride, liquid nitrogen and liquid helium are employed as cooling media for the low-temperature cooling apparatus, and accordingly, such a low-temperature cooling apparatus must be carefully constructed such that neither condensation nor frosting will occur, and thus the performance of the electronic equipment will not be adversely affected.

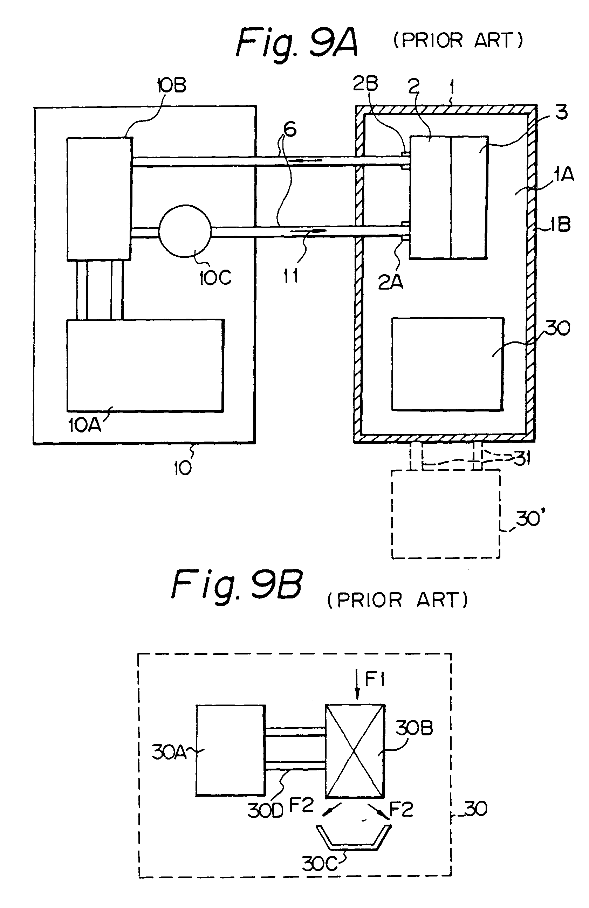

Known cooling apparatuses have a configuration as shown in Figure 9. Figure 9A is a configuration diagram, and Figure 9B is an explanatory diagram of a dehumidification unit shown in Fig. 9A.

As shown in Figure 9A, an airtight case 1 made of a heat insulating material accommodates a cooling module 2 and electronic equipment 3. The cooling module 2 is coupled to a cooling medium supply unit 10 via a pipeline 6, and the electronic equipment 3 is cooled by circulating a cooling medium 11 (designated by arrows) through the cooling module 2.

The cooling medium supply unit 10 is equipped with a refrigerator 10A for cooling a heat exchanger 10B and a pump 10C for feeding the cooling medium 11 cooled by the heat exchanger 10B. The cooling medium 11 from the heat exchanger 10B passes through the pipeline 6 and flows to a supply port 2A of the cooling module 2, and then flows out of a feedback port 2B of the cooling module 2 to be fed back to the heat exchanger 10B via the pipeline 6, to thereby circulate the cooling medium.

Furthermore, as shown in Figure 9B, a dehumidification unit 30 comprising a refrigerator 30A for circulating the cooling medium to a heat exchanger 30B via a pipeline 30D, to cool the heat exchanger 30B, and a drain pan 30C for retaining water droplets generated by a cooled air taken in by the heat exchanger 30B, is incorporated in the airtight case 1, to thereby dehumidify the air in an internal chamber 1A of the airtight case 1 and lower the dew-point temperature thereof.

In a cooling system using the dehumidification unit 30 as constructed above, upon dehumidification, the chamber 1A becomes cooler than the outside atmosphere, and therefore, the airtight case 1 must be made of a heat insulating material so that no absorption of external heat by the chamber 1A occurs. Furthermore, the dehumidification unit 30 may be installed outside the airtight case 1, as indicated by a phantom line 30′ in Figure 9A, wherein an air pipe 31 draws the internal air from the chamber 1A of the airtight case 1 into the dehumidification unit 30′ and thus achieves the required dehumidification.

The airtight case 1 is provided with a door 1B able to be opened for a maintenance inspection of the cooling module 2, the electronic equipment 3, or the dehumidification unit 30 accommodated inside the airtight case 1.

To circulate the cooling medium 11 in the cooling module 2 and thereby cool the electronic equipment 3, the refrigerator 30A of the dehumidification unit 30 is first driven to draw the internal air from the chamber 1A of the airtight case 1 into the heat exchanger 30B as indicated by an arrow F1 (Fig. 9B). Then, the refrigerator 10A and the pump 10C in the cooling medium supply unit 10 is driven to start the supply of the cooling medium 11, to cool the electronic equipment 3.

Namely, the cooling of the electronic equipment 3 is preceded by a dehumidifying of the chamber 1A.

In a conventional cooling system employing such a dehumidification unit 30 composed of a refrigerator 30A and a heat exchanger 30B, to dehumidify the internal chamber 1A of the airtight case 1, an expensive refrigerator 30A providing a temperature lower than the temperature of the cooling medium 11 must be incorporated in the dehumidification unit 30, in addition to and independently of the cooling medium supply unit 10 having its own refrigerator 10A. This results in a complex system configuration and an increase in costs.

A primary object of the present invention is to provide a new cooling apparatus in which a cooling medium circulated in the cooling module is utilized to lower the dew-point temperature in the airtight case, to thereby prevent condensation and frosting.

According to the present invention, there is provided an electronic equipment cooling apparatus comprising an airtight case having an internal chamber, a cooling module located in the airtight case for cooling an electronic equipment to be cooled, a first heat exchanger located in the airtight case for dehumidifying the internal chamber of the airtight case, an external cooling medium supply unit located outside the airtight case, for feeding a cooling medium, and a pipeline connecting the external cooling medium supply unit, the cooling module and the first heat exchanger to thereby circulate therethrough the cooling medium from the external cooling medium supply unit in the cooling module and the first heat exchanger, and thus lower a dew-point temperature of the airtight case.

With this arrangement, the cooling medium is circulated in the cooling module through the first heat exchanger, and thus the dehumidification is effected by the first heat exchanger.

Accordingly, the cooling of the electronic equipment and the dehumidification of the airtight case is effected by the cooling medium fed from the cooling medium supply unit, and as a result, the dehumidification unit 30 (Fig. 9) considered indispensable in the prior art, can be omitted to thereby simplify the construction thereof and reduce costs.

Preferably, in the above-mentioned arrangement, the airtight case is made of a heat insulating material.

Also, preferably a drain pan is provided below the first heat exchanger in the airtight case, to receive and retain water droplets from the first heat exchanger.

A second heat exchanger connected to the first heat exchanger in the airtight case through a duct can be provided to receive an exhaust from the first heat exchanger. The second heat exchanger contributes to an increase of the temperature of the exhaust. With this structure, the air temperature within the internal chamber of the airtight case is raised to a given value by the second heat exchanger, and accordingly, the internal temperature of the airtight case is maintained at substantially the same level as the ambient outside temperature. Therefore, it is not necessary to make the airtight case of a heat insulating material, and this further reduces the manufacturing cost.

Preferably, the cooling module, the electronic equipment, and the pipeline are surrounded by a heat insulating member.

For a better understanding of the invention, and to show how the same may be carried into effect, reference will now be made, by way of example, to the accompanying drawings, in which:
Figure 1 is an explanatory view showing the principle of the present invention, according to a first aspect thereof;
Figure 2 is an explanatory view showing the principle of the present invention, according to a second aspect thereof;
Figure 3A is an explanatory view of an embodiment of the first aspect of the invention, shown in Fig. 1;
Figs. 3B and 3C are diagrams of temperature distributions in an arrangement shown in Fig. 3A;
Figure 4A is an explanatory view of an embodiment of the second aspect of the invention shown in Fig. 2;
Fig. 4B is a diagram of a temperature distribution in an arrangement shown in Fig. 4A;
Figure 5 is a partial explanatory view of another embodiment of the present invention;
Figure 6A is a partial explanatory view of still another embodiment of the present invention;
Fig. 6B is a diagram of a temperature distribution in an arrangement shown in Fig. 6A;
Figure 7A is a partial explanatory view of still another embodiment of the present invention;
Fig. 7B is a diagram of a temperature distribution in an arrangement shown in Fig. 7A;
Fig. 7C is a view showing a modified arrangement of Fig. 7A;
Figure 8A is a partial explanatory view of still another embodiment of the present invention;
Fig. 8B is a diagram of a temperature distribution in an arrangement shown in Fig. 8A;
Fig. 8C is a view showing a modified arrangement of Fig. 8A;
Figure 9A is an explanatory view of a known cooling apparatus; and,
Fig. 9B is an enlarged view of a known dehumidification unit shown in Fig. 9A.

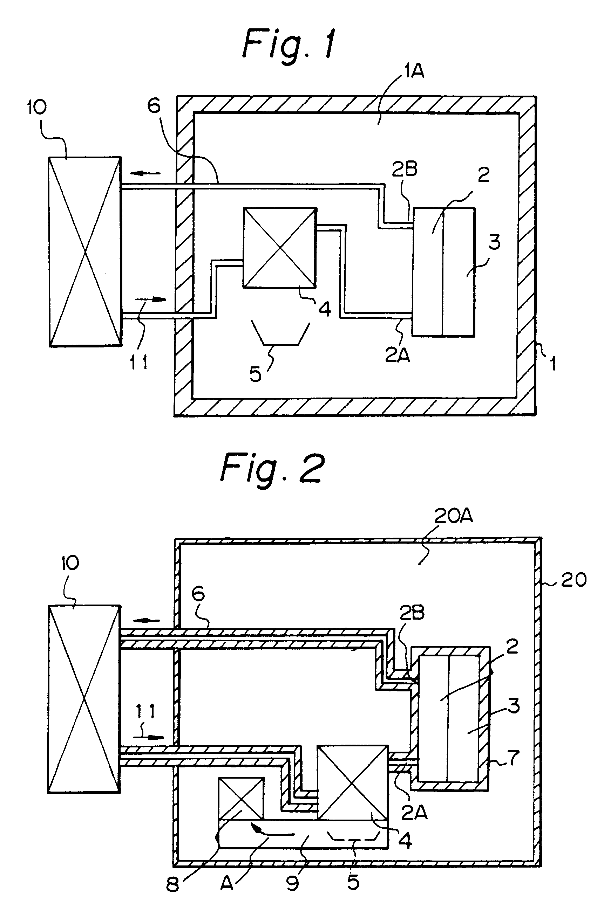

First, two arrangements according to two basic aspects of the present invention will be discussed with reference to Figures 1 and 2.

A cooling apparatus, according to a first aspect of the present invention shown in Figure 1, comprises a cooling module 2 for cooling electronic equipment 3, a first heat exchanger 4 for dehumidification, a drain pan 5 for retaining water droplets generated by the first heat exchanger 4, and an airtight case 1 accommodating the cooling module 2, the electronic equipment 3, the first heat exchanger 4, and the drain pan 5. (The airtight case 1 is made of a heat insulating material.) A cooling medium 11 (designated by arrows) flows through pipeline 6 from a cooling medium supply unit 10 outside the airtight case 1 and is circulated through the cooling module 2 and the first heat exchanger 4 to thereby lower the dew-point temperature of an internal chamber 1A of the airtight case 1. Numerals 2A and 2B designate a supply port and feedback port of the cooling module 2, respectively.

A cooling apparatus, according to a second aspect of the present invention shown in Figure 2, comprises a cooling module 2 for cooling electronic equipment 3, a first heat exchanger 4 for dehumidification, a drain pan 5 for retaining water droplets generated by the first heat exchanger 4, and a second heat exchanger 8 for drawing an exhaust A from the first heat exchanger 4 via a duct 9 and raising the temperature of the exhaust A to a given value, and an airtight case 20 accommodating the cooling module 2, the electronic equipment 3, the first heat exchanger 4, the drain pan 5, and the second heat exchanger 8. A pipeline 6 allows the cooling medium 11 from a cooling medium supply unit 10 to circulate through the cooling module 2 and the first heat exchanger 4. Also, the cooling module 2, the electronic equipment 3, and the pipeline 6 are provided with a heat insulating material 7 as a cooling or surrounding thereof. The first heat exchanger 4 lowers the dew-point temperature in an internal chamber 20A of the airtight case 20.

According to the first aspect of the invention, the cooling medium 11 circulating through the cooling module 2 in the airtight case 1 made of a heat insulating material also circulates through the first heat exchanger 4, which then dehumidifies the chamber 1A.

Therefore, the supply of the cooling medium 11 ensures a cooling of the electronic equipment 3 and a dehumidifying of the chamber 1A. This allows a conventional dehumidification unit 30 (Figs. 9A, 9B) including a refrigerator 30A to be omitted, resulting in a simplified configuration and reduced costs, as mentioned before.

According to the second aspect of the invention, the cooling medium 11 circulating through the cooling module 2 in the airtight case 20 is also circulated in the first heat exchanger 4, which then dehumidifies the chamber 20A. The second heat exchanger 8 raises the temperature of the exhaust A from the first heat exchanger 4 to a given value.

Thus, the second aspect of the invention ensures a dehumidification of the chamber 1A in the same way as the first aspect of the invention. Furthermore, the temperature of the chamber 20A in the airtight case 20 can be kept at a value substantially matching that of the outside temperature, and therefore, the airtight case 20 need not always be made of a heat insulating material.

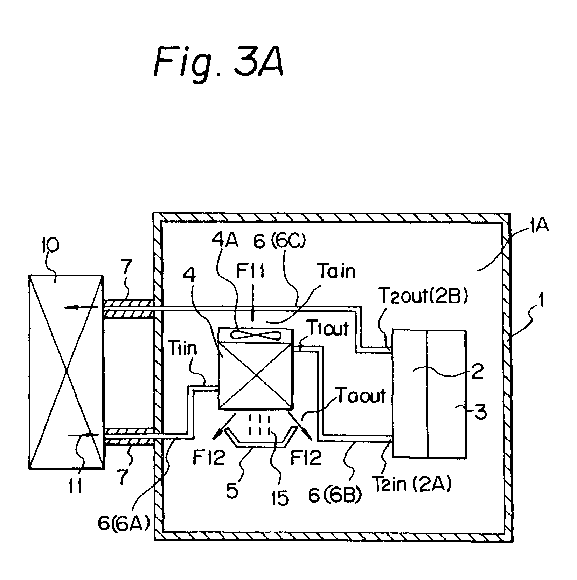

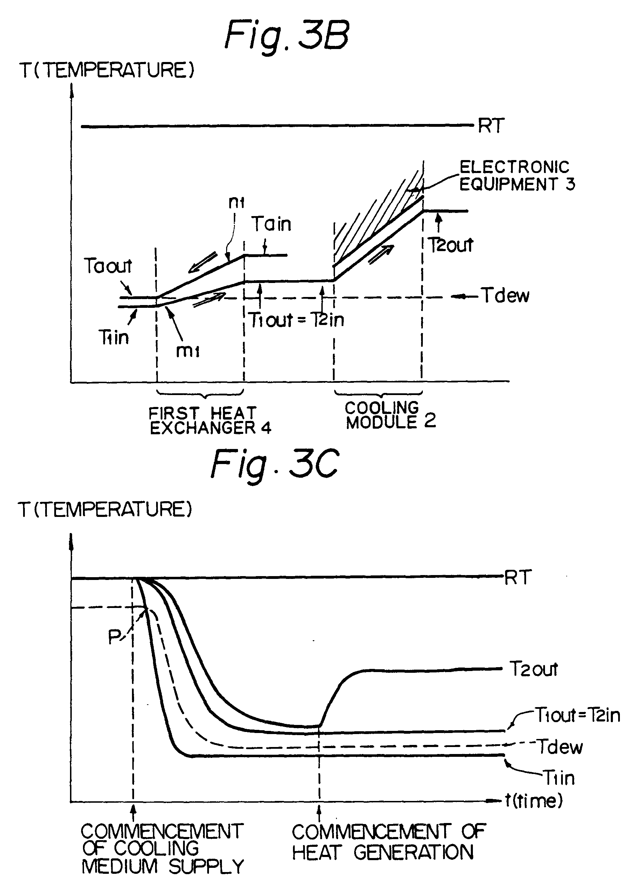

Figure 3 is an explanatory view of a first embodiment of the first invention shown in Fig. 1. Figure 3A is a configuration diagram, and Figures 3B and 3C are temperature distribution graphs thereof. The same symbols used in the different drawings represent the same elements.

In Figure 3A, the first heat exchanger 4 and the drain pan 5 are arranged in the airtight case 1, accommodating the cooling module 2 for cooling the electronic equipment 3 attached thereto, made of a heat insulating material. A pipe 6A forming a part of the pipeline 6 is coupled between the cooling medium supply unit 10 outside the case 1 and the first heat exchanger 4, and a pipe 6B forming the pipeline 6 is coupled between the first heat exchanger 4 and the cooling module 2, and a pipe 6C forming the pipeline 6 is coupled between the cooling module 2 and the cooling medium supply unit 10, respectively.

The first heat exchanger 4, which is, per se, known, is equipped with a fan 4A, for drawing air from the chamber 1A into the first heat exchanger 4, as indicated by an arrow F11, and exhausting the air therefrom as indicated by an arrow F12.

The cooling medium 11 cooled to a given low temperature is supplied from the cooling medium supply unit 10 to the first heat exchanger 4 via the pipe 6A. After circulating in the first heat exchanger 4, the cooling medium flows out of the first heat exchanger 4, to the supply port 2A of the cooling module 2 via the pipe 6B. After circulating in the cooling module 2, the cooling medium flows to the feedback port 2B of the cooling module 2 and is then fed back to the cooling medium supply unit 10 via the pipe 6C.

In this case, the pipes 6A and 6C exposed between the airtight case 1 and the cooling medium supply unit 10 can be coated with or surrounded by a heat insulating material or member 7, to prevent a temperature rise therein due to a higher outside air temperature.

In the foregoing configuration, if the cooling medium 11 has a temperature lower than a room temperature RT (Fig. 3B) the temperature change is represented as a curve m1 of Figure 3B. The first heat exchanger 4 cools the air in the chamber 1A to lower the temperature from Tₐᵢₙ to Tₐₒᵤₜ, on a curve n1, and thus raises the temperature of the cooling medium 11 from T₁ᵢₙ to T₁ₒᵤₜ. Water droplets 15 generated by rapidly cooling the air in the chamber 1A are retained in the drain pan 5 located below the heat exchanger 4, and thus the chamber 1A is dehumidified. The cooling module 2 absorbs heat dissipated from the electronic equipment 3 to raise the temperature of the cooling medium 11 from T₂ᵢₙ to T₂ₒᵤₜ.

With circulation of the cooling medium 11, the first heat exchanger 4 is first actuated to obtain a dehumidifying effect, and this lowers the dew-point temperature T_{dew} to a low value indicated by a dashed line, which eventually prevents an occurrence of condensation and frosting during the cooling by the cooling module 2.

Figure 3C shows the temperature characteristics of each element in an arrangement shown in Figure 3A. The abscissa designates the time. In Fig. 3C, when the supply of the cooling medium is commenced, the temperature T₁ᵢₙ, T₁ₒᵤₜ (= T₂ᵢₙ) of the cooling medium is gradually lowered. Then, due to the heat capacity of the heat exchanger 4 and the heat exchange between the heat exchanger 4 and the ambient air thereof, T₁ₒᵤₜ, becomes higher than T₁ᵢₙ (T₁ₒᵤₜ > T₁ᵢₙ), and further, since the cooling module has a large heat capacity, T₂ₒᵤₜ becomes higher than T₂ᵢₙ (T₂ₒᵤₜ > T₂ᵢₙ) until completely cooled.

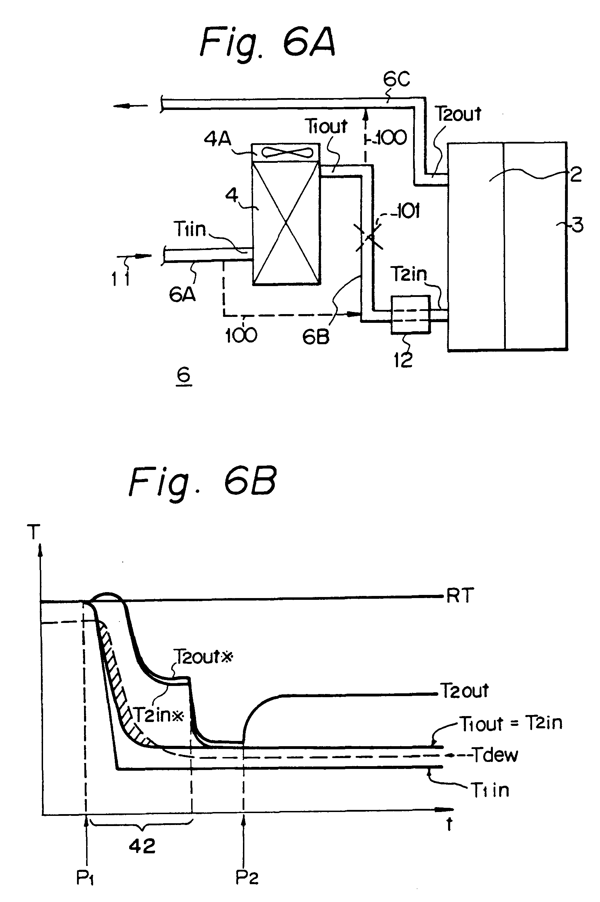

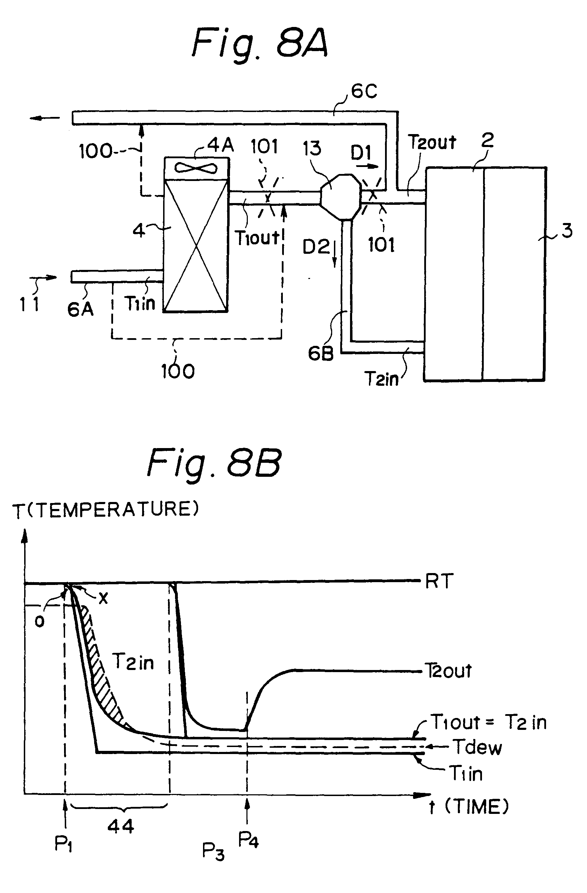

At the point P (Fig. 3C), at which T₁ᵢₙ becomes lower than the initial dew-point temperature T_{dew}, the dehumidification by the heat exchanger 4 starts, and thus T_{dew} begins to fall. Although T_{dew} < T₁ₒᵤₜ does not always hold, it is possible to provide the relationship T_{dew} < T₁ₒᵤₜ, by appropriately determining the factors of the heat exchanger 4 (dehumidification capability, heat capacity, etc.), as shown in Figs. 6B and 8B. Furthermore, since the temperature (not shown) of the electronic equipment 3 when in operation is always higher than T₂ᵢₙ, and accordingly T₁ₒᵤₜ, no condensation occurs at the electronic equipment 3.

The time at which the start of the heat generation commences can be defined, for example, by a time lapse from the commencing of the supply of the cooling medium, etc., since the temperature changes at each components tend to remain approximately constant at the beginning of the cooling medium supply.

In the aforesaid configuration, the amount of water vapor in the chamber 1A is limited, and therefore, the amount of water droplets 15 to be retained in the drain pan 5 is also limited, and need not be drained away.

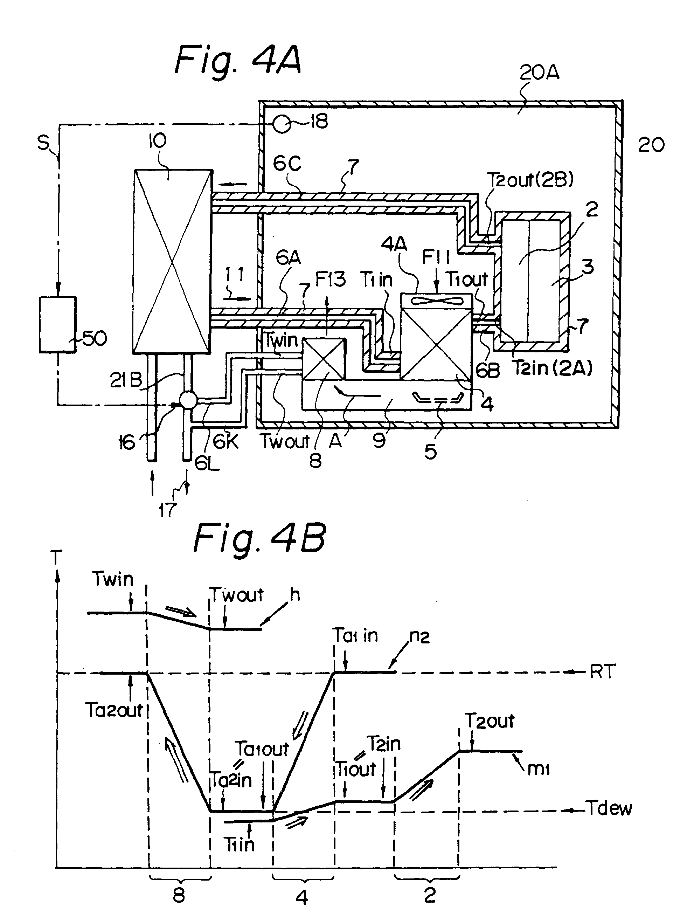

In Figure 4A, the first heat exchanger 4, the drain pan 5, and a second heat exchanger 8 similar to the first heat exchanger 4 are arranged in the airtight case 20 accommodating the cooling module 2 for cooling the electric equipment 3 connected thereto. The pipe 6A is coupled between the cooling medium supply unit 10 and the first heat exchanger 4, the pipe 6B is coupled between the first heat exchanger 4 and the cooling module 2, the pipe 6C is coupled between the cooling module 2 and the cooling medium supply unit 10, respectively. The electronic equipment 3, the cooling module 2, and the pipes 6A, 6B, and 6C are coated with or surrounded by the heat insulating material or member 7.

A duct 9 runs between the first heat exchanger 4 and the second heat exchanger 8, to allow the exhaust A to be expelled from the first heat exchanger 4 to the second heat exchanger 8. The drain pan 5 is incorporated in the duct 9. The fan 4A of the first heat exchanger 4 is actuated to draw air from the chamber 20A into the first heat exchanger 4, as indicated by an arrow F11. The exhaust A from the first heat exchanger 4 is drawn into the second heat exchanger 8, which then raises the temperature of the exhaust A and expels the exhaust A to the chamber 20A as indicated by an arrow F13.

To raise the temperature of the exhaust A, for example, a valve 16 (e.g., two-way valve) is formed at an outlet pipe 21B of a cooling water circulating in the cooling medium supply unit 10, pipes 6K and 6L are connected to the second heat exchanger 8, and a temperature sensor 18 is incorporated in the chamber 20A. Therefore, when the temperature sensor 18 senses a given temperature, the valve 16 is switched in accordance with a detection signal S through a controller 50 to provide the second heat exchanger 8 with high-temperature waste water 17, via the pipes 6K and 6L, so that the temperature of the chamber 20A matches that of the outside air. The second heat exchanger 8 may be provided with a heater. This also permits an adjustment of the temperature of the chamber 20A, depending on the reference temperature set by the sensor 18.

Then, the cooling medium 11 cooled to a given low temperature is supplied from the cooling medium supply unit 10 to the first heat exchanger 4 via the pipe 6A, and after being circulated in the first heat exchanger 4, the cooling medium flows out of the first heat exchanger 4 to the supply port 2A of the cooling module 2 via the pipe 6B. After being circulated in the cooling module 2, the cooling medium flows out of the feedback port 2B of the cooling module 2, and is fed back to the cooling medium supply unit 10 via the pipe 6C. On the other hand, the exhaust A from the first heat exchanger 4 is heated to a given temperature by the second heat exchanger 8, and thus the temperature of the chamber 20A matches that of the outside air.

In this case, the electronic equipment 3, the cooling module 2, and the pipes 6A, 6B, and 6C are preferably coated with or surrounded by the heat insulating material or member 7. Nevertheless, the airtight case 20 need not be always coated with a heat insulating material, and therefore, can be formed at a lower cost than that of the airtight case 1 in the first aspect of the invention.

In the foregoing configuration, when the cooling medium 11 has a temperature lower than a room temperature RT, the temperature change is represented as a curve m1 in Figure 4B. The first heat exchanger 4 cools the air in the chamber 20A to lower the temperature from Tₐ₁ᵢₙ to Tₐ₁ₒᵤₜ, on a curve n2, and thus raises the temperature of the cooling medium 11 from T₁ᵢₙ to T₁ₒᵤₜ. Water droplets generated by the rapid cooling of the air of the chamber 20A are retained in the drain pan 5, to thus dehumidify the chamber 20A. The cooling module 2 absorbs heat dissipated from the electronic equipment 3, to raise the temperature of the cooling medium 11 from T₂ᵢₙ to T₂ₒᵤₜ, and the second heat exchanger 8 lowers the temperature of the high-temperature waste water 17 from T_{win} to T_{wout}, on a curve h, to raise the temperature of the exhaust A expelled by the second heat exchanger 8 from Tₐ₂ᵢₙ to Tₐ₂ₒᵤₜ, and thus the temperature of exhaust expelled from the second heat exchanger 8, as indicated by an arrow F13, substantially matches the room temperature RT.

In the aforesaid configuration, similar to the previous configuration, a circulation of the cooling medium 11 causes the first heat exchanger 4 to first perform a dehumidification. This lowers the dew-point temperature T_{dew} to a low value indicated by a dashed line in Fig. 4B, and eventually prevents an occurrence of condensation and frosting during the cooling by the cooling module 2.

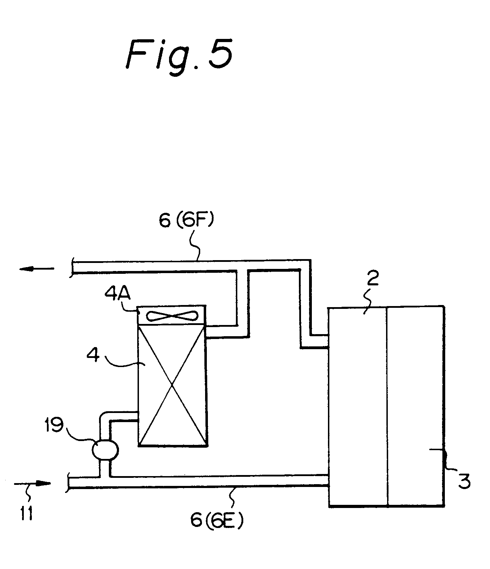

In the configurations shown in Figures 3A and 4A, the first heat exchanger 4 and the cooling module 2 are coupled in series using the pipes 6A, 6B, and 6C. Alternatively, as shown in Figure 5, pipes 6E and 6F forming the pipeline 6 may be employed such that the first heat exchanger 4 and the cooling module 2 are coupled in parallel. In this case, for example, a control valve 19 is provided at an inlet of the first heat exchanger 4 through which the cooling medium supply unit 10 supplies the cooling medium 11, to thereby adjust the flow rate of the cooling medium supplied to the first heat exchanger 4 and the cooling module 2. The control valve 19 controls the passage area of the pipeline 6 in which the valve 19 is located.

In Figure 6A, a heater 12 for heating the cooling medium 11 supplied to the cooling module 2 is mounted on the pipe 6B.

At the start of the cooling, first the heater 12 is energized and the cooling medium 11 is circulated, and then the first heat exchanger 4 is actuated to provide a dehumidification effect. Thereafter, the heater 12 is de-energized, and the electronic equipment 3 is operated, and finally, the cooling module starts the cooling process.

The temperature of the circulating cooling medium 11 at the inlet of the first heat exchanger 4 drops from a point P1 or the temperature at the start of cooling to T₁ᵢₙ as shown in Figure 6B, and the temperature at the outlet of the first heat exchanger 4 becomes T₁ₒᵤₜ. Therefore, the dehumidification in the first heat exchanger causes the dew-point temperature of the chamber 1A or 20A to drop, as indicated by a dashed line.

Further, the heater 12 is energized to temporarily raise the temperatures of the cooling medium 11 in the cooling module 2 to T₂ᵢₙ* and T₂ₒᵤₜ* during the dehumidification. Then, when the dew-point temperature T_{dew} fully drops (i.e., when a time represented by 42 in Fig. 6B has lapsed from the point P₁), the heater 12 is de-energized, and at a point P2, the electronic equipment 3 is operated. Thereafter, the temperature of the cooling medium 11 at the feedback port of the cooling medule 2 is raised to T₂ₒᵤₜ, to cool the electronic equipment 3.

After the dew-point temperature T_{dew} of the chamber 1A or 20A drops, the cooling module 2 starts the cooling operation, and therefore, even if the temperature of the cooling medium 11 is relatively abruptly lowered after the cooling is started, neither condensation nor frosting occurs.

Note, in an example shown in Fig. 6B, as can be seen in a hatched area thereof, the dew-point temperature T_{dew} is temporarily higher than the temperature of the cooling medium 11 at the outlet of the first heat exhanger 4, and accordingly, condensation may occur in the cooling module 2 or the electronic equipment 3.

In this case, when the arrangement of the pipes 6A, 6B, and 6C is modified as indicated by imaginary lines 100, the first heat exchanger 4 and the cooling module 2 are coupled in parallel. The mark "phantom cross" 101 denotes that the pipeline bearing the same does not exist in the modified arrangement. Namely, in the modified arrangement, the passage labelled "phantom cross" is replaced by the passage designated by the imaginary line 100. This modified configuration also provides the aforesaid advantages.

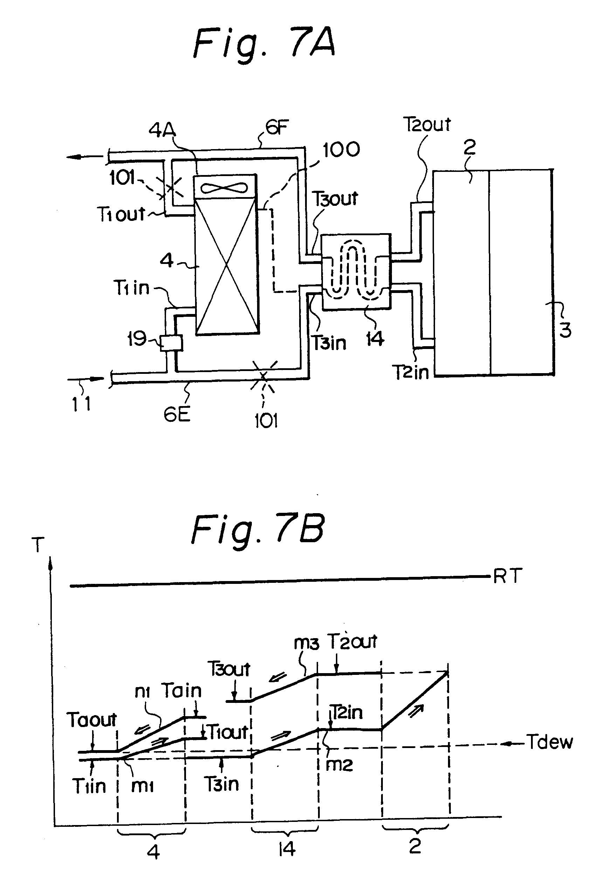

In Figure 7A, a third heat exchanger 14 is mounted on the pipes 6E and 6F forming the pipeline 6 for coupling the first heat exchanger 4 and the cooling module 2. In the third heat exchanger 14, the cooling media 11 supplied to and fed back from the cooling module 2, to thus mutually exchange heat with each other.

When the cooling medium supply unit 10 supplies the cooling medium 11, the electronic equipment 3 is operated at the same time, and thus the temperature of the cooling medium 11 supplied to the cooling module 2 is retained at a high level by the third heat exchanger 14.

Figure 7B shows a temperature change of the cooling medium in this case. First, the first heat exchanger 4 raises the temperature of the cooling medium 11 from T₁ᵢₙ to T₁ₒᵤₜ, on a curve m1, and thus cools the air of the chamber 1A or 20A to lower the temperature from Tₐᵢₙ to Tₐₒᵤₜ, on a curve n1, which causes the dew-point temperature T_{dew} to drop. Next, the third heat exchanger 14 raises the temperature of the cooling medium 11 from T₃ᵢₙ to T₂ᵢₙ on a curve m2, then the cooling module 2 raises the temperature of the cooling medium 11 from T₂ᵢₙ to T₂ₒᵤₜ, and finally, the third heat exchanger 14 cools the fed-back cooling medium to lower the temperature from T₂ₒᵤₜ, to T₃ₒᵤₜ, on a curve m3.

In this case, even when the cooling medium supply unit 10 and the electronic equipment 3 are operated simultaneously, the cooling will not cause either condensation or frosting.

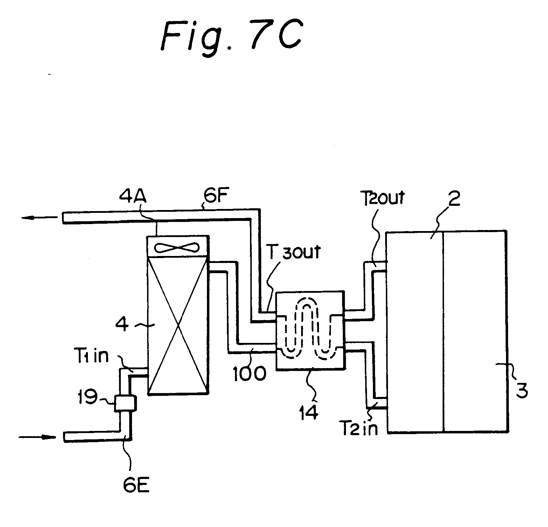

If the arrangement of the pipes 6E and 6F is modified as indicated by an imaginary line 100, the first heat exchanger 4 and the cooling module 2 are coupled in series. Fig. 7C shows the modified arrangement of Fig. 7A, for reference. This modified configuration also provides the aforesaid advantages.

In Figure 8A, a valve 13 is provided between the pipe 6B coupling the first heat exchanger 4 with the cooling module 2 and the pipe 6C for feeding back the cooling medium from the cooling module 2. The cooling medium 11 flowing out of the first heat exchanger 4 is supplied to the cooling module 2 or fed back directly to the cooling medium supply unit 10 according to the operation of the valve 3, which is, for example, a two-way valve. The valve 13 controls the flow of the cooling medium 11 in the cooling module 2.

At the start of cooling, the cooling medium 11 flowing out of the first heat exchanger 4 is fed back directly to the cooling medium supply unit 10, as indicated by an arrow D1, whereby the chamber 1A or 20A is dehumidified. Thereafter, the cooling medium 11 flowing out of the first heat exchanger 4 is supplied to the cooling module 2, as indicated by an arrow D2, to thus cool the electronic equipment 3.

The temperature of the circulating cooling medium 11 at an inlet of the first heat exchanger 4 drops, as shown in Figure 8B, from a point P1 or the temperature at the start of coooling to T₁ᵢₙ, and the temperature at an outlet of the first heat exchanger 4 becomes T₁ₒᵤₜ. Therefore, the dehumidification in the first heat exchanger 4 causes the dew-point temperature T_{dew} of the chamber 1A or 20A to drop, as indicated by a dashed line.

Further, the valve 13 is switched so that no cooling medium 11 is supplied to the cooling module 2 during the dehumidification, and when the dew-point temperature T_{dew} drops, the valve 13 is switched so that the cooling medium 11 can be supplied to the cooling module at a point P3, and as a result, the temperature of the cooling medium at the inlet of the cooling module 2 drops to T₂ᵢₙ. The electronic equipment 3 is operated at a point P4, and after the cooling medium 11 is circulated through the cooling module 2, to cool the electronic equipment 3, the temperature of the cooling medium 11 rises to T₂ₒᵤₜ.

Similar to the previous configuration (Fig. 6A), after the dew-point temperature of the chamber 1A or 20A drops, the cooling module 2 starts a cooling operation, and therefore, condensation and frosting can be prevented.

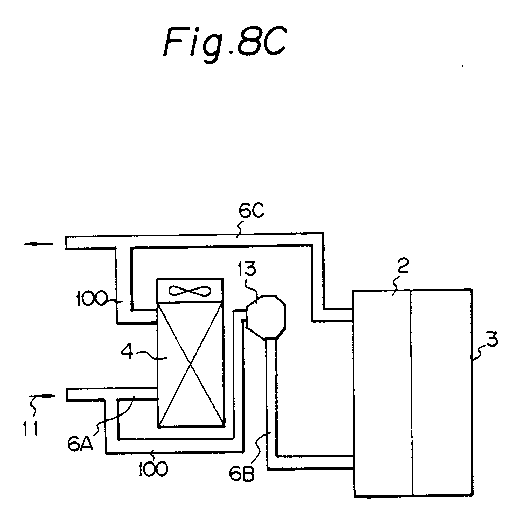

In this case, the arrangement of the pipes 6A, 6B, and 6C may be modified so that the first heat exchanger 4 and cooling module 2 can be coupled in paralle, as shown in Fig. 8C. This modified configuration also provides the aforesaid advantages.

As described previously, according to the present inventions, cooling by a cooling module is preceded by a dehumidification by a first heat exchanger, which prevents an occurrence of condensation and frosting during cooling by the cooling module.

Therefore, faults resulting from the condensation and frosting do not occur, thus ensuring a stable operation. Moreover, a special dehumidification unit equipped with a refrigerator need not be installed, thus simplifying the system configuration and reducing costs.

## Claims

1. An electronic equipment cooling apparatus comprising:
an airtight case (1, 20) having an internal chamber (1A, 20A);
a cooling module (2) located in the airtight case for cooling an electronic equipment (3) to be cooled;
a first heat exchanger (4) located in the airtight case for dehumidifying the internal chamber of the airtight case;
an external cooling medium supply unit (10) located outside the airtight case for feeding a cooling medium; and,
a pipeline (6) connecting the external cooling medium supply unit, the cooling module and the first heat exchanger for a circulation therethrough of the cooling medium from the external cooling medium supply unit in the cooling module and the first heat exchanger, to thereby lower a dew-point temperature in the airtight case.

2. A cooling apparatus according to claim 1, wherein said airtight case (1) is made of a heat insulating material.

3. A cooling apparatus according to claim 1 or 2, further comprising a heat insulating member (7) surrounding a portion of the pipeline (6) located outside the airtight case (1).

4. A cooling apparatus according to claim 1, 2 or 3, further comprising a reservoir (5) in the airtight case for holding water droplets from the first heat exchanger (4).

5. A cooling apparatus according to claim 4, wherein said reservoir (5) is a drain pan located below the first heat exchanger (4).

6. A cooling apparatus according to any preceding claim, further comprising a second heat exchanger (8) connected to the first heat exchanger (4) in the airtight case through a duct (9) to receive an exhaust from the first heat exchanger (4) and increase a temperature of the exhaust.

7. A cooling apparatus according to any preceding claim, further comprising a heat insulating means (7) for thermally insulating the cooling module (2), the electronic equipment (3) and the pipeline (6).

8. A cooling apparatus according to claim 7, wherein said heat insulating means (7) comprises a heat insulating member surrounding the cooling module (2), the electronic equipment (3) and the pipeline (6).

9. A cooling apparatus according to any preceding claim, wherein said cooling module (2) and said first heat exchanger (4) are connected to each other in series by said pipeline (6), so that the first heat exchanger is located upstream of the cooling module.

10. A cooling apparatus according to any one of claims 1 to 8, wherein said cooling module (2) and said first heat exchanger (4) are connected to each other in parallel by said pipeline (6).

11. A cooling apparatus according to any preceding claim, further comprising a heater (12) provided in the pipeline (6) directly connected to an inlet of the cooling module (2).

12. A cooling apparatus according to any preceding claim, further comprising a third heat exchanger (14) in the pipeline (6) between the first heat exchanger (4) and the cooling module (2).

13. A cooling apparatus according to claim 12, wherein the portions of the pipeline connected to the cooling module and located upstream and downstream of the cooling module are close to each other in the third heat exchanger (14), whereby a heat exchange of the cooling medium at the upstream and downstream pipeline portions can be effectively carried out.

14. A cooling apparatus according to any preceding claim, further comprising a valve (13) in the pipeline (6) between the first heat exchanger (4) and the cooling module (2), to selectively stop the flow of the cooling medium in the cooling chamber.

15. A cooling apparatus according to claim 14, wherein the pipeline (6) comprises a bypass passage bypassing the cooling module and in which the first heat exchanger is provided.

## Patentansprüche

1. Kühlvorrichtung für eine elektronische Apparatur, welche aufweist:
ein luftdichtes Gehäuse (1, 20) mit einer Innenkammer (1A, 20A);
ein in dem luftdichten Gehäuse angeordnetes Kühlmodul (2) zur Kühlung einer zu kühlenden elektronischen Apparatur (3);
einen in dem luftdichten Gehäuse angeordneten ersten Wärmetauscher (4) zum Entfeuchten der Innenkammer des luftdichten Gehäuses;
eine außerhalb des luftdichten Gehäuses angeordnete Kühlmedium-Zuführeinheit (10) für die Förderung eines Kühlmediums; und
eine Rohrleitung (6), welche die externe Kühlmedium-Zuführeinheit, das Kühlmodul und den ersten Wärmetauscher für eine Zirkulation des Kühlmediums hierdurch von der Kühlmedium-Zuführeinheit im Kühlmodul und dem ersten Wärmetauscher verbindet, um dadurch eine Taupunkttemperatur in dem luftdichten Gehäuse zu senken.

2. Kühlvorrichtung nach Anspruch 1, dadurch gekennzeichnet, daß das luftdichte Gehäuse (1) aus einem wärmedämmenden Material hergestellt ist.

3. Kühlvorrichtung nach Anspruch 1 oder 2, welche des weiteren ein Wärmedämmelement (7) aufweist, das einen Abschnitt der außerhalb des luftdichten Gehäuses (1) angeordneten Rohrleitung (6) umgibt.

4. Kühlvorrichtung nach Anspruch 1, 2 oder 3, welche des weiteren ein Reservoir (5) in dem luftdichten Gehäuse zum Zurückhalten von Wassertröpfchen aus dem ersten Wärmetauscher (4) aufweist.

5. Kühlvorrichtung nach Anspruch 4, dadurch gekennzeichnet, daß das Reservoir (5) eine unter dem ersten Wärmetauscher (4) angeordnete Ablaufwanne ist.

6. Kühlvorrichtung nach einem der vorhergehenden Ansprüche, welche des weiteren einen zweiten Wärmetauscher (8) aufweist, der mit dem ersten Wärmetauscher (4) in dem luftdichten Gehäuse durch eine Leitung (9) verbunden ist, um Abluft von dem ersten Wärmetauscher (4) aufzunehmen und die Temperatur der Abluft zu erhöhen.

7. Kühlvorrichtung nach einem der vorhergehenden Ansprüche, welche des weiteren ein Wärmedämmittel (7) zur Wärmedämmung des Kühlmoduls (2), der elektronischen Apparatur (3) und der Rohrleitung (6) aufweist.

8. Kühlvorrichtung nach Anspruch 7, dadurch gekennzeichnet, daß das Wärmedämmittel (7) ein Wärmedämmelement aufweist, welches das Kühlmodul (2), die elektronische Apparatur (3) und die Rohrleitung (6) umgibt.

9. Kühlvorrichtung nach einem der vorhergehenden Ansprüche, dadurch gekennzeichnet, daß das Kühlmodul (2) und der erste Wärmetauscher (4) durch die Rohrleitung (6) in Reihe miteinander verbunden sind, so daß der erste Wärmetauscher stromaufwärts von dem Kühlmodul angeordnet ist.

10. Kühlvorrichtung nach einem der Ansprüche 1 bis 8, dadurch gekennzeichnet, daß das Kühlmodul (2) und der erste Wärmetauscher (4) durch die Rohrleitung (6) parallel miteinander verbunden sind.

11. Kühlvorrichtung nach einem der vorhergehenden Ansprüche, welche des weiteren eine Heizvorrichtung (12) aufweist, die in der direkt mit einem Einlaß des Kühlmoduls (2) verbundenen Rohrleitung (6) vorgesehen ist.

12. Kühlvorrichtung nach einem der vorhergehenden Ansprüche, welche des weiteren einen dritten Wärmetauscher (14) in der Rohrleitung (6) zwischen dem ersten Wärmetauscher (4) und dem Kühlmodul (2) aufweist.

13. Kühlvorrichtung nach Anspruch 12, dadurch gekennzeichnet, daß die mit dem Kühlmodul verbundenen und stromaufwärts und stromabwärts vom Kühlmodul angeordneten Abschnitte der Rohrleitung im dritten Wärmetauscher (14) nahe beieinander liegen, wodurch ein Wärmeaustausch des Kühlmediums an den stromaufwärts und stromabwärts befindlichen Abschnitten der Rohrleitung wirksam durchgeführt werden kann.

14. Kühlvorrichtung nach einem der vorhergehenden Ansprüche, welche des weiteren in der Rohrleitung (6) zwischen dem ersten Wärmetauscher (4) und dem Kühlmodul (2) ein Ventil (13) aufweist, um den Fluß des Kühlmediums in der Kühlkammer selektiv anzuhalten.

15. Kühlvorrichtung nach Anspruch 14, dadurch gekennzeichnet, daß die Rohrleitung (6) eine Bypass-Passage aufweist, welche das Kühlmodul umgeht und in welcher der erste Wärmetauscher vorgesehen ist.

## Revendications

1. Appareil de refroidissement pour un équipement électronique, comprenant :
- un boîtier étanche à l'air (1, 20) qui comporte une chambre intérieure (1A, 20A) ;
- un module de refroidissement (2) situé dans le boîtier étanche à l'air afin de refroidir un équipement électronique (3) qui doit être refroidi ;
- un premier échangeur thermique (4) situé dans le boîtier étanche à l'air, afin de déshumidifier la chambre intérieure du boîtier étanche à l'air ;
- une unité de fourniture extérieure (10) en fluide de refroidissement, située à l'extérieur du boîtier étanche pour fournir un fluide de refroidissement ; et
- une conduite (6) qui relie l'unité de fourniture extérieure en fluide de refroidissement, le module de refroidissement et le premier échangeur thermique afin que le fluide de refroidissement circule à travers ladite conduite depuis l'unité de fourniture extérieure jusque dans le module de refroidissement et dans le premier échangeur thermique, pour abaisser ainsi une température de point de rosée dans le boîtier étanche.

2. Appareil de refroidissement selon la revendication 1, dans lequel ledit boîtier étanche (1) est réalisé en un matériau thermiquement isolant.

3. Appareil de refroidissement selon l'une ou l'autre des revendications 1 et 2, comprenant en outre un élément thermiquement isolant (7) qui entoure une partie de la conduite (6) située à l'extérieur du boîtier étanche (1).

4. Appareil de refroidissement selon l'une quelconque des revendications 1, 2 ou 3, comprenant en outre un réservoir (5) dans le boîtier étanche afin de retenir les gouttelettes d'eau depuis le premier échangeur thermique (4).

5. Appareil de refroidissement selon la revendication 4, dans lequel ledit réservoir (5) est une auge de drainage située au-dessous du premier échangeur thermique (4).

6. Appareil de refroidissement selon l'une quelconque des revendications précédentes, comprenant en outre un second échangeur de chaleur (8) relié au premier échangeur thermique (4) dans le boîtier étanche par l'intermédiaire d'un conduit (9) afin de recevoir un échappement depuis le premier échangeur thermique (4) et d'augmenter la température de l'échappement.

7. Appareil de refroidissement selon l'une quelconque des revendications précédentes, comprenant en outre des moyens d'isolation thermique (7) afin d'isoler thermiquement le module de refroidissement (2), l'équipement électronique (3) et la conduite (6).

8. Appareil de refroidissement selon la revendication 7, dans lequel lesdits moyens d'isolation thermique (7) comprennent un élément thermiquement isolant qui entoure le module de refroidissement (2), l'équipement électronique (3) et la conduite (6).

9. Appareil de refroidissement selon l'une quelconque des revendications précédentes, dans lequel ledit module de refroidissement (2) et ledit premier échangeur thermique (4) sont raccordés l'un à l'autre en série par ladite conduite (6), de sorte que le premier échangeur thermique est situé en amont du module de refroidissement.

10. Appareil de refroidissement selon l'une quelconque des revendications 1 à 8, dans lequel ledit module de refroidissement (2) et ledit premier échangeur thermique (4) sont raccordés l'un à l'autre en parallèle au moyen de ladite conduite (6).

11. Appareil de refroidissement selon l'une quelconque des revendications précédentes, comprenant en outre une unité de chauffage (12) prévue dans la conduite (6) directement reliée à une entrée du module de refroidissement (2).

12. Appareil de refroidissement selon l'une quelconque des revendications précédentes, comprenant en outre un troisième échangeur thermique (14) dans la conduite (6) entre le premier échangeur thermique (4) et le module de refroidissement (2).

13. Appareil de refroidissement selon la revendication 12, dans lequel les parties de la conduite reliées au module de refroidissement et situées en amont et en aval du module de refroidissement sont proches l'une de l'autre dans le troisième échangeur thermique (14), grâce à quoi on peut effectivement procéder à un échange thermique du fluide de refroidissement au niveau des parties amont et aval de la conduite.

14. Appareil de refroidissement selon l'une quelconque des revendications précédentes, comprenant en outre une valve (13) dans la conduite (6) entre le premier échangeur thermique (4) et le module de refroidissement (2), afin d'arrêter sélectivement l'écoulement du fluide de refroidissement dans la chambre de refroidissement.

15. Appareil de refroidissement selon la revendication 14, dans lequel la conduite (6) comprend un passage de contournement qui contourne le module de refroidissement, et dans lequel est prévu le premier échangeur thermique.
